# EUROPÄISCHE PATENTANMELDUNG

(11) **EP 4 336 139 A1**
(43) Veröffentlichungstag der Anmeldung: **13.03.2024**
(21) Anmeldenummer: 23194569.2
(22) Anmeldetag: 31.08.2023
(51) Int. Cl.: G01B 9/02, G01B 9/02055, G02B 5/10, G01B 11/24, G03F 7/20

(54) **VERFAHREN ZUM KALIBRIEREN EINER SPHÄRISCHEN WELLE, SOWIE PRÜFSYSTEM ZUR INTERFEROMETRISCHEN BESTIMMUNG DER OBERFLÄCHENFORM EINES PRÜFLINGS**

(30) Priorität: 12.09.2022 DE 102022209513
(71) Anmelder: Carl Zeiss SMT GmbH, 73447 Oberkochen (DE)
(72) Erfinder: Hetzler, Jochen, 73447 Oberkochen (DE); Dreher, Matthias, 73447 Oberkochen (DE); Jennewein, Holger, 73447 Oberkochen (DE)
(74) Vertreter: Frank, Hartmut

(57) **Zusammenfassung**

Die Erfindung betrifft ein Verfahren zum Kalibrieren einer sphärischen Welle, sowie ein Prüfsystem zur interferometrischen Bestimmung der Oberflächenform eines Prüflings. Bei einem erfindungsgemäßen Verfahren zum Kalibrieren einer sphärischen Welle, wobei diese sphärische Welle in einem Prüfsystem erzeugt wird, welches zur interferometrischen Bestimmung der Oberflächenform eines Prüflings (120) ausgelegt ist, und wobei zum Kalibrieren der sphärischen Welle wenigstens ein sphärischer Kalibrierspiegel (130, 230) verwendet wird, auf welchen die sphärische Welle gelenkt wird, erfolgt das Kalibrieren der sphärischen Welle basierend auf einer Mehrzahl von nacheinander durchgeführten interferometrischen Messungen, welche sich hinsichtlich des jeweils von dem sphärischen Kalibrierspiegel reflektierten Teilbereichs der zu kalibrierenden sphärischen Welle voneinander unterscheiden.

## Beschreibung

Die vorliegende Anmeldung beansprucht die Priorität der Deutschen Patentanmeldung DE 10 2022 209 513.8, angemeldet am 12. September 2022. Der Inhalt dieser DE-Anmeldung wird durch Bezugnahme ("incorporation by reference") mit in den vorliegenden Anmeldungstext aufgenommen.

### HINTERGRUND DER ERFINDUNG

### Gebiet der Erfindung

Die Erfindung betrifft ein Verfahren zum Kalibrieren einer sphärischen Welle, sowie ein Prüfsystem zur interferometrischen Bestimmung der Oberflächenform eines Prüflings.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet. Typische für EUV ausgelegte Projektionsobjektive, wie z.B. aus US 2016/0085061 A1 bekannt, können beispielsweise eine bildseitige numerische Apertur (NA) im Bereich von NA = 0.55 aufweisen und bilden ein (z.B. ringsegmentförmiges) Objektfeld in die Bildebene bzw. Waferebene ab. Mit der Erhöhung der bildseitigen numerischen Apertur (NA) geht typischerweise eine Vergrößerung der erforderlichen Spiegelflächen der in der Projektionsbelichtungsanlage eingesetzten Spiegel einher. Dies hat wiederum zur Folge, dass neben der Fertigung auch die Prüfung der Oberflächenform der Spiegel eine anspruchsvolle Herausforderung darstellt.

Hierbei kommen zur hochgenauen Prüfung der Spiegel insbesondere interferometrische Messverfahren unter Verwendung Computer-generierter Hologramme (CGH) zum Einsatz. Dabei basiert die Bestimmung der Oberflächenform des jeweiligen Spiegels bzw. Prüflings auf einer interferometrischen Überlagerung einer von dem CGH erzeugten Prüfwelle mit an die Soll-Form der Oberfläche des Prüflings angepasster Wellenfront und einer Referenzwelle. Hierbei ist es weiter bekannt, eine Kalibrierung zur Berücksichtigung von durch die Messanordnung bzw. das CGH bewirkten Wellenfrontfehlern durchzuführen. Bekannte Ansätze hierzu beinhalten z.B. den Einsatz zusätzlicher Kalibrierspiegel in Kombination mit einer Erzeugung entsprechender, zusätzlicher Kalibrierwellen durch das CGH. Hierzu kann das CGH eine komplexe Kodierung in Form einander überlagernder diffraktiver Strukturmuster zur Erzeugung der Prüfwelle, der Referenzwelle sowie der Kalibrierwellen aufweisen.

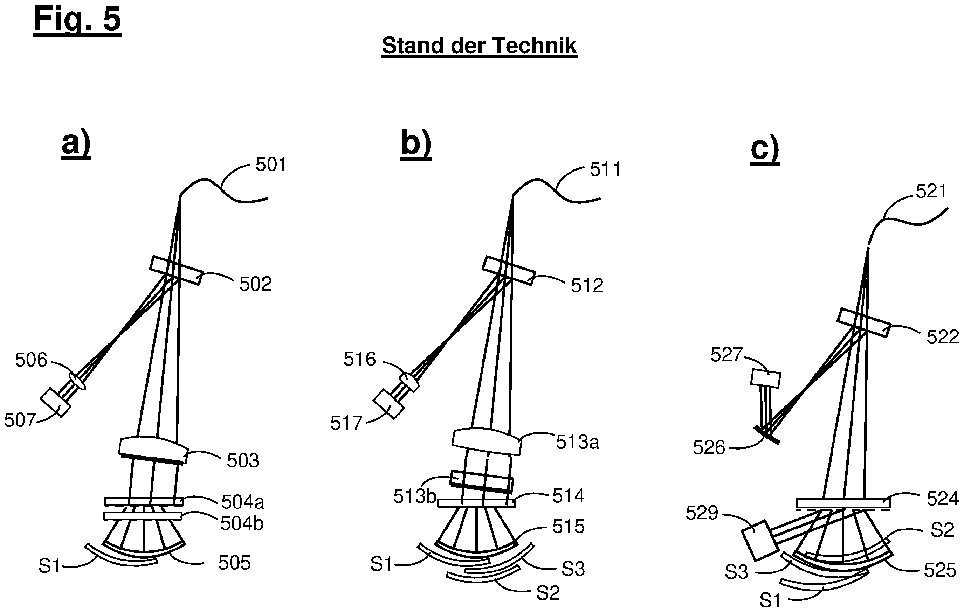

Fig. 5a-5c zeigen in lediglich schematischer Darstellung unterschiedliche bekannte Anordnungen zur Realisierung des vorstehend beschriebenen Prüfkonzepts.

Fig. 5a zeigt die Realisierung in einer sogenannten Fizeau-Anordnung. Hierbei gelangt von einer (nicht dargestellten) Lichtquelle erzeugte elektromagnetische Strahlung über eine optische Faser 501 und einen Strahlteiler 502 zu einem Fizeau-Element 503, welches im konkreten Beispiel als Fizeau-Kollimator ausgestaltet ist und zum einen in für sich bekannter Weise durch Reflexion die zur interferometrischen Messung benötigte Referenzwelle erzeugt und zum anderen hinsichtlich des durch das Fizeau-Element 503 transmittierten Strahlungsanteils einen kollimierten Strahlengang bereitstellt. Die durch das Fizeau-Element 503 transmittierte Strahlung trifft gemäß Fig. 5a auf ein erstes CGH 504a sowie anschließend auf ein zweites CGH 504b. Die Kombination der Beugung in der (+1)-ten Beugungsordnung des ersten CGHs 504a mit der Beugung in der (+1)-ten Beugungsordnung des zweiten CGHs 504 erzeugt eine Prüfwelle mit an die Soll-form der Oberfläche eines nachfolgenden (insbesondere asphärischen) Prüflings 505 angepasster Wellenfront (d.h. die Wellenfront der Prüfwelle entspricht mathematisch exakt der "Prüflingsform"). Die Kombination der (+1)-ten Beugungsordnung des ersten CGHs 504a mit der Beugung in der (-1)-ten Beugungsordnung des zweiten CGHs 504b erzeugt eine Kalibierwelle, welche auf einen sphärischen Kalibrierspiegel S1 trifft. Mit Hilfe der Messung des sphärischen Kalibrierspiegels S1 lässt sich der Interferometerfehler für die Messung des Prüflings 505 bestimmen. Dabei ist essenziell, dass die interferometrische Anordnung mit Ausnahme des Wechsels von Kalibrierspiegel S1 zu asphärischem Prüfling 505 idealerweise (bis auf Driften) nicht geändert wird. Die besagte Prüfwelle bzw. die Kalibierwelle gelangt über die CGH`s 504b und 504a sowie das Fizeau-Element 503 ebenso wie die Referenzwelle zurück zum Strahlteiler 502 und wird von diesem zu einer Interferometerkamera 507 gelenkt, wobei sie ein Okular 506 durchläuft. Die Interferometerkamera 507 erfasst ein durch die interferierenden Wellen erzeugtes Interferogramm, aus dem über eine (nicht dargestellte) Auswerteeinrichtung die Oberflächenform des Prüflings 505 bestimmt wird.

Gemäß Fig. 5b (in welcher zu Fig. 5a analoge bzw. im Wesentlichen funktionsgleiche Komponenten mit um "10" erhöhten Bezugsziffern bezeichnet sind) erzeugt ein CGH 514 durch geeignete komplexe Kodierung zusätzlich zur Prüfwelle weitere Ausgangswellen insbesondere in Form mehrerer Kalibrierwellen, welche an unterschiedlichen Kalibrierspiegeln S1-S3 reflektiert und ebenfalls mit der Referenzwelle interferometrisch in der Messanordnung überlagert werden. Dabei sind im Unterschied zu Fig. 5a anstelle eines Fizeau-Kollimators ein Kollimator 513a und ein separates Fizeau-Element 513b vorgesehen.

Fig. 5c (in welcher wiederum zu Fig. 5b analoge bzw. im Wesentlichen funktionsgleiche Komponenten mit um "10" erhöhten Bezugsziffern bezeichnet sind) zeigt eine Realisierung in einer Michelson-Interferometeranordnung mit einem diffraktiven Strahlteiler oder einer sogenannten "Referenzspiegel-Anordnung", wobei in für sich bekannter Weise ein Referenzspiegel 529, welcher im optischen Strahlengang nach dem CGH 524 angeordnet ist, die für die interferometrische Messung erforderliche und vom CGH 524 erzeugte Referenzwelle reflektiert.

Den vorstehend beschriebenen Ansätzen ist gemeinsam, dass wenigstens eine von einem CGH erzeugte sphärische Kalibrierwelle in einem Einsatzszenario des jeweiligen Prüfsystems an einem sphärischen Kalibrierspiegel reflektiert wird, wodurch letztlich in für sich bekannter Weise eine Separierung von Fehlern innerhalb der Messanordnung (insbesondere des CGH's) von Fehlern des hinsichtlich seiner Oberflächenform zu charakterisierenden Prüflings erreicht werden soll.

Ein hierbei in der Praxis auftretendes Problem ist, dass weder die in den vorstehend beschriebenen Szenarien verwendete(n), vom CGH erzeugte(n) sphärische(n) Kalibrierwelle(n) noch der diese sphärische Kalibrierwelle(n) jeweils reflektierende sphärische Kalibrierspiegel perfekt bzw. fehlerfrei sind mit der Folge, dass auch insoweit eine Kalibrierung hinsichtlich der besagten sphärischen Kalibrierwelle(n) (im Sinne einer Unterscheidung von Fehlern dieser sphärischen Kalibrierwelle von Fehlern der Messanordnung bzw. des die Kalibrierwelle reflektierenden sphärischen Kalibrierspiegels) geboten ist.

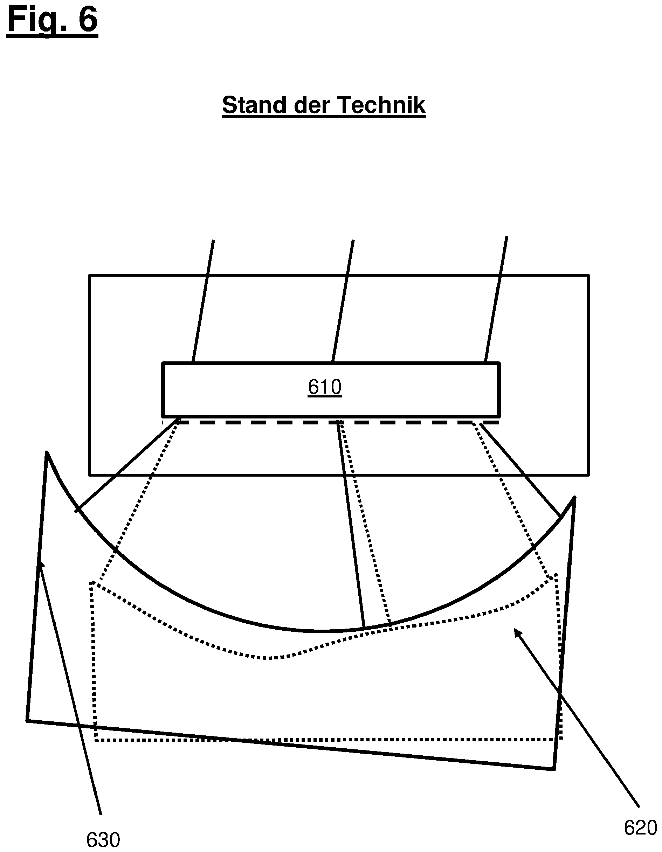

Ein weiter in der Praxis auftretendes Problem ist, dass - wie in der schematischen Darstellung von Fig. 6 angedeutet - mit zunehmender Größe des letztlich in der Prüfanordnung hinsichtlich seiner Oberflächenform zu charakterisierenden Prüflings (in Fig. 6 mit "630" bezeichnet) und einer damit einhergehenden Zunahme der Größe der verwendeten CGH's ("610" in Fig. 6) auch die Abmessungen des sphärischen Kalibrierspiegels ("630" in Fig. 6) ansteigen. Dabei kommt erschwerend hinzu, dass die Abmessungen des sphärischen Kalibrierspiegels diejenigen des letztlich zu charakterisierenden Prüflings (welche lediglich beispielhaft in der Größenordnung von 0.5 m liegen können) noch übersteigen.

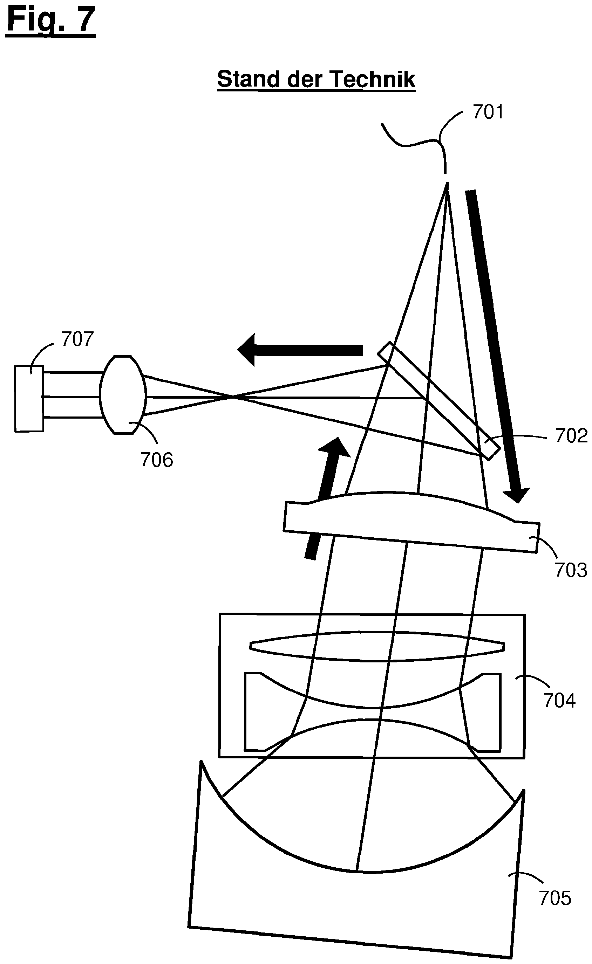

Fig. 7 zeigt ein weiteres Anwendungsbeispiel für einen sphärischen Kalibrierspiegel, wobei es sich hierbei gemäß Fig. 7 um die Kalibrierung einer sphärischen Welle handelt, welche als Prüfwelle zur Charakterisierung der Oberflächenform eines eine sphärische optische Wirkfläche aufweisenden Prüflings handelt. Auch hier gelangt elektromagnetische Strahlung über eine optische Faser 701 und einen Strahlteiler 702 zu einem als Fizeau-Kollimator ausgestalteten Fizeau-Element 703, wobei die besagte sphärische Prüfwelle aus der vom Fizeau-Element 703 ausgehenden kollimierten Welle über eine ("Aplanar")-Optik 704 erzeugt wird. Nach Reflexion am Prüfling oder auch am sphärischen Kalibrierspiegel 705 gelangt die Prüfwelle über die Optik 704 und das Fizeau-Element 703 zurück zum Strahlteiler 702 und wird von diesem über ein Okular 706 zu einer Interferometerkamera 707 gelenkt.

Zum Stand der Technik wird lediglich beispielhaft auf DE 10 2015 202 695 A1, DE 10 2017 217 372 A1, DE 10 2017 217 371 A1, US 6,956,657 B2, DE 10 2006 035 022 A1 sowie die Publikationen D. Su et al.: "Absolute surface figure testing by shift-rotation method using Zernike polynomials", Opt. Lett. 37, 3198-3200 (2012), und C. Supranowitz et al.: "Fabrication and metrology of high-precision freeform surfaces," Proc. SPIE 8884, Optifab 2013, 888411 (15 October 2013); doi: 10.1117/12.2030144 verwiesen.

### ZUSAMMENFASSUNG DER ERFINDUNG

Vor dem obigen Hintergrund ist es eine Aufgabe der vorliegenden Erfindung, ein Verfahren zum Kalibrieren einer sphärischen Welle sowie ein Prüfsystem zur interferometrischen Bestimmung der Oberflächenform eines Prüflings, bereitzustellen, welche eine zuverlässige Kalibrierung auch für die Prüfung von vergleichsweise großen Spiegelflächen unter zumindest teilweiser Vermeidung der vorstehend beschriebenen Probleme ermöglichen.

Diese Aufgabe wird durch die Merkmale der unabhängigen Patentansprüche gelöst.

Gemäß einem Aspekt betrifft die Erfindung ein Verfahren zum Kalibrieren einer sphärischen Welle, wobei diese sphärische Welle in einem Prüfsystem erzeugt wird, welches zur interferometrischen Bestimmung der Oberflächenform eines Prüflings ausgelegt ist, und wobei zum Kalibrieren der sphärischen Welle wenigstens ein sphärischer Kalibrierspiegel verwendet wird, auf welchen die sphärische Welle gelenkt wird.

Das Verfahren ist dadurch gekennzeichnet, dass das Kalibrieren der sphärischen Welle basierend auf einer Mehrzahl von nacheinander durchgeführten interferometrischen Messungen erfolgt, welche sich hinsichtlich des jeweils von dem sphärischen Kalibrierspiegel reflektierten Teilbereichs der zu kalibrierenden sphärischen Welle voneinander unterscheiden.

Zusätzlich zu einer Verschiebung (zur Erfassung eines jeweils anderen Teilbereichs) kann der sphärische Kalibrierspiegel auch rotiert werden, insbesondere um eine Achse, welche durch den Scheitel seiner sphärischen Fläche und das Zentrum der zugehörigen Kugelwelle verläuft. Damit ändert sich die Orientierung der sphärischen Fläche zum Prüfsystem, ohne dass sich notwendigerweise der reflektierte Ausschnitt der Prüfwelle ändert. Vorzugsweise werden beide Bewegungen - Verschiebung (Shift) und Drehung (Rotation) - in der Kalibrierprozedur angewendet, um die Fehler von Spiegel und Prüfsystem zu trennen, wobei die Verschiebung hilft, mit einer vergleichsweise kleinen Sphäre die gesamte Prüfwelle abzutasten.

Infolge der erfindungsgemäßen Durchführung aufeinanderfolgender interferometrischen Messungen für unterschiedliche, jeweils vom sphärischen Kalibrierspiegel reflektierte Teilbereiche der zu kalibrierenden sphärischen Welle kann der sphärische Kalibrierspiegel vergleichsweise geringere Abmessungen (im Vergleich zu einer Erfassung der gesamten zu kalibrierenden sphärischen Welle in einer einzigen interferometrischen Messung) aufweisen. Dabei wird erfindungsgemäß für die Durchführung der Mehrzahl von interferometrischen Messungen bewusst ein höherer Messaufwand in Kauf genommen, um im Gegenzug u.a. die mit einer Reduzierung der Größe des verwendeten sphärischen Kalibrierspiegels verbundenen Vorteile zu erzielen.

"Kalibrierung einer sphärischen Welle" oder "Kalibrierung der Kalibrierwelle" bedeutet somit, dass eine potentiell fehlerbehaftete Kalibrierwelle, welche vom CGH erzeugt wird, mittels mehrerer nacheinander durchgeführter interferometrischer Messungen zu einer fehlerfreien Kalibrierwelle rechnerisch zusammengesetzt wird. Die Kalibrierwelleninformation, insbesondere die interferometrische Information der an einem sphärischen Kalibrierspiegel reflektierten Kalibrierwelle, wird somit durch die miteinander Verrechnung der Einzelmessungen zu einer besonders genauen Kalibrierwelleninformation. Dies führt insbesondere zu genaueren Messergebnissen bezüglich einer Oberflächenform eines zu vermessenden optischen Elements.

Der Erfindung liegt somit insbesondere das Konzept zugrunde, in einem interferometrischen Prüfsystem zur Kalibrierung einer sphärischen Welle (bei welcher es sich gemäß Fig. 7 um eine Prüfwelle oder auch gemäß Fig. 5a-5c selbst um eine Kalibrierwelle handeln kann) nicht einen vergleichsweise großen, den gesamten Prüfbereich bzw. den gesamten Bereich der zu kalibrierenden sphärischen Welle abdeckenden Kalibrierspiegel zu verwenden, sondern stattdessen mit einem vergleichsweise kleineren sphärischen Kalibrierspiegel nur einen Teilbereich der zu kalibrierenden sphärischen Welle abzudecken und dann die Ergebnisse mehrerer interferometrischer Messungen, welche nacheinander für unterschiedliche Teilbereiche der zu kalibrierenden sphärischen Welle durchgeführt werden, miteinander zu verrechnen. Auf diese Weise können im Ergebnis die einleitend beschriebenen, bei der Verwendung eines vergleichsweise großen sphärischen Kalibrierspiegels auftretenden Nachteile vermieden oder zumindest wesentlich reduziert werden.

Hinsichtlich der in den nacheinander durchgeführten interferometrischen Messungen jeweils erfassten bzw. vom sphärischen Kalibrierspiegel reflektierten unterschiedlichen Teilbereiche der zu kalibrierenden sphärischen Welle liegt der Erfindung die weitere Überlegung zugrunde, dass ein sich hierbei angesichts der Unerreichbarkeit einer perfekten Justage des sphärischen Kalibrierspiegels und des CGH`s relativ zueinander ergebendes prinzipielles "Stitching-Problem" im Wege einer rechnerischen Korrektur, und insbesondere wie im Weiteren noch näher erläutert unter Heranziehung eines Überlappbereichs der bei den unterschiedlichen interferometrischen Messungen erfassten Teilbereiche sowie Lösung eines Optimierungsproblems (bei dem die entsprechenden Positionierungsfreiheitsgrade rechnerisch gerade so bestimmt werden, dass die sich im Überlappbereich ergebenden relativen Abweichungen minimiert werden) gelöst werden kann.

Mit anderen Worten macht sich die Erfindung in vorteilhafter Weise den Umstand zu Nutze, dass in besagtem Überlappbereich zusätzliche Information in Form der aus den einzelnen interferometrischen Messungen jeweils bereitgestellten Interferogrammphasen bzw. Wellenfrontwerten zur Verfügung steht, wobei diese zusätzliche Information es wiederum ermöglicht, die prinzipiell unvermeidbaren Unsicherheiten hinsichtlich der Justage des sphärischen Kalibrierspiegels in seinen drei Freiheitsgraden als im Wege einer Optimierung bestimmbare Variablen zugrundezulegen.

Gemäß einer Ausführungsform wird zur Reflexion der unterschiedlichen Teilbereiche der sphärischen Welle ein- und derselbe sphärische Kalibrierspiegel in unterschiedliche Positionen bewegt.

Gemäß einer Ausführungsform weisen wenigstens zwei in unterschiedlichen dieser interferometrischen Messungen erfasste Teilbereiche der sphärischen Welle einen gemeinsamen Überlappbereich auf. Dabei kann insbesondere eine rechnerische Korrektur der in der Mehrzahl von interferometrischen Messungen jeweils erhaltenen Messdaten unter Berücksichtigung von relativen Abweichungen der bei diesen interferometrischen Messungen für den Überlappbereich jeweils erhaltenen Messdaten erfolgen.

Gemäß einer Ausführungsform beträgt die Anzahl der sich hinsichtlich des reflektierten Teilbereichs der zu kalibrierenden sphärischen Welle voneinander unterscheidenden durchgeführten interferometrischen Messungen wenigstens drei, insbesondere wenigstens vier.

Gemäß einer Ausführungsform wird die sphärische Welle in dem Prüfsystem als Prüfwelle bei der interferometrischen Bestimmung der Oberflächenform eines sphärischen Prüflings erzeugt.

Gemäß einer weiteren Ausführungsform wird die sphärische Welle in dem Prüfsystem als Kalibrierwelle bei der interferometrischen Bestimmung der Oberflächenform eines asphärischen Prüflings erzeugt. Dabei kann insbesondere bei dieser interferometrischen Bestimmung der Oberflächenform des asphärischen Prüflings eine durch Beugung elektromagnetischer Strahlung an einem Computer-generierten Hologramm (CGH) erzeugte und an dem Prüfling reflektierte Prüfwelle mit einer nicht an dem Prüfling reflektierten Referenzwelle überlagert werden.

Gemäß einer Ausführungsform ist der Prüfling ein optisches Element einer mikrolithographischen Projektionsbelichtungsanlage.

Gemäß einer Ausführungsform ist der Prüfling ein Spiegel oder eine Linse.

Die Erfindung betrifft weiter auch ein Prüfsystem zur interferometrischen Bestimmung der Oberflächenform eines Prüflings, insbesondere eines optischen Elements einer mikrolithographischen Projektionsbelichtungsanlage, wobei das Prüfsystem zum Kalibrieren einer in dem Prüfsystem in einer Konfiguration erzeugten sphärische Welle einen sphärischen Kalibrierspiegel aufweist, welcher zur Reflexion unterschiedlicher Teilbereiche der sphärischen Welle in unterschiedliche Positionen bewegbar ist.

Gemäß einer Ausführungsform ist das Prüfsystem dazu ausgelegt, ein Verfahren mit den vorstehend beschriebenen Merkmalen durchzuführen.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: eine schematische Darstellung zur Erläuterung einer beispielhaften Anwendung des erfindungsgemäßen Verfahrens in einem ein CGH aufweisenden interferometrischen Prüfsystem;
- Figur 2: eine schematische Darstellung zur Erläuterung einer weiteren möglichen Anwendung des erfindungsgemäßen Verfahrens in einem zur Charakterisierung der Oberflächenform eines sphärischen Prüflings ausgelegten interferometrischen Prüfsystem;
- Figur 3a-3c: Diagramme zur Erläuterung eines in einem erfindungsgemäßen Verfahren durchgeführten Stitching-Prozesses in einer ersten Ausführungsform;
- Figur 4a-4c: Diagramme zur Erläuterung eines in einem erfindungsgemäßen Verfahren durchgeführten Stitching-Prozesses in einer weiteren Ausführungsform;
- Figur 5a-5c: schematische Darstellungen unterschiedlicher herkömmlicher Konzepte zur interferometrischen Charakterisierung der Oberflächenform eines sphärischen Prüflings unter Verwendung wenigstens eines CGH's;
- Figur 6: eine schematische Darstellung zur Veranschaulichung einer herkömmlichen Kalibrierung einer von einem CGH als Kalibrierwelle erzeugten sphärischen Welle;
- Figur 7: eine schematische Darstellung eines herkömmlichen Prüfsystems mit einer sphärischen Prüfwelle zur Charakterisierung der Oberflächenform eines sphärischen Prüflings; und
- Figur 8: eine schematische Darstellung einer für den Betrieb im EUV ausgelegten Projektionsbelichtungsanlage.

### DETAILLIERTE BESCHREIBUNG BEVORZUGTER AUSFÜHRUNGSFORMEN

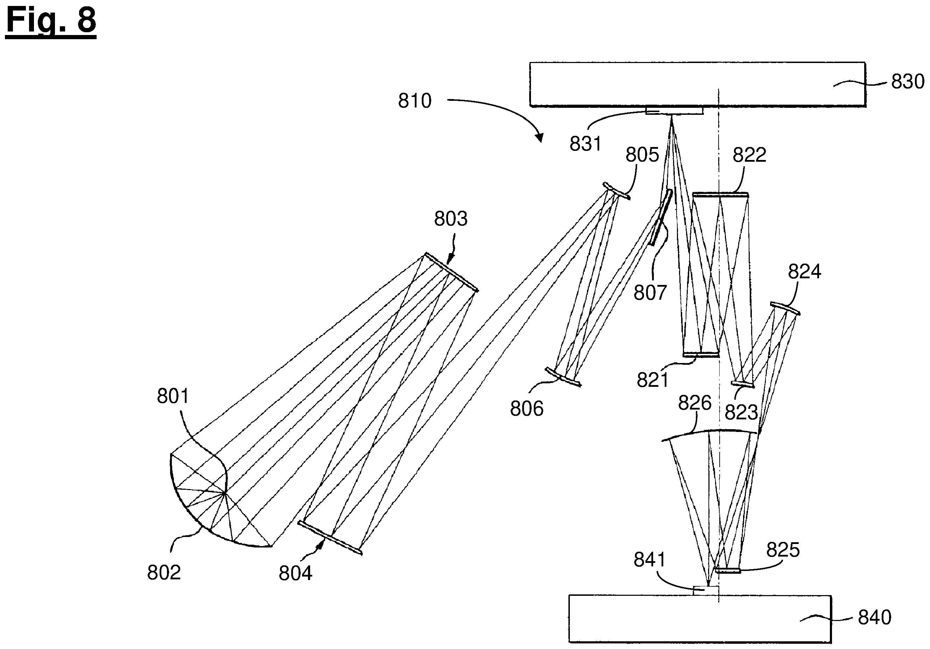

Fig. 8 zeigt zunächst eine schematische Darstellung einer beispielhaften für den Betrieb im EUV ausgelegten Projektionsbelichtungsanlage, welche mit einem erfindungsgemäßen Prüfsystem prüfbare Spiegel aufweist.

Gemäß Fig. 8 weist eine Beleuchtungseinrichtung in einer für EUV ausgelegten Projektionsbelichtungsanlage 810 einen Feldfacettenspiegel 803 und einen Pupillenfacettenspiegel 804 auf. Auf den Feldfacettenspiegel 803 wird das Licht einer Lichtquelleneinheit, welche eine Plasmalichtquelle 801 und einen Kollektorspiegel 802 umfasst, gelenkt. Im Lichtweg nach dem Pupillenfacettenspiegel 804 sind ein erster Teleskopspiegel 805 und ein zweiter Teleskopspiegel 806 angeordnet. Im Lichtweg nachfolgend ist ein Umlenkspiegel 807 angeordnet, der die auf ihn treffende Strahlung auf ein Objektfeld in der Objektebene eines sechs Spiegel 821-826 umfassenden Projektionsobjektivs lenkt. Am Ort des Objektfeldes ist eine reflektive strukturtragende Maske 831 auf einem Maskentisch 830 angeordnet, die mit Hilfe des Projektionsobjektivs in eine Bildebene abgebildet wird, in welcher sich ein mit einer lichtempfindlichen Schicht (Photoresist) beschichtetes Substrat 841 auf einem Wafertisch 840 befindet.

Bei dem mit einem Prüfsystem gemäß der Erfindung hinsichtlich seiner Oberflächenform zu charakterisierenden Prüfling kann es sich z.B. (ohne dass die Erfindung hierauf beschränkt wäre) um einen beliebigen Spiegel der Projektionsbelichtungsanlage 810 handeln.

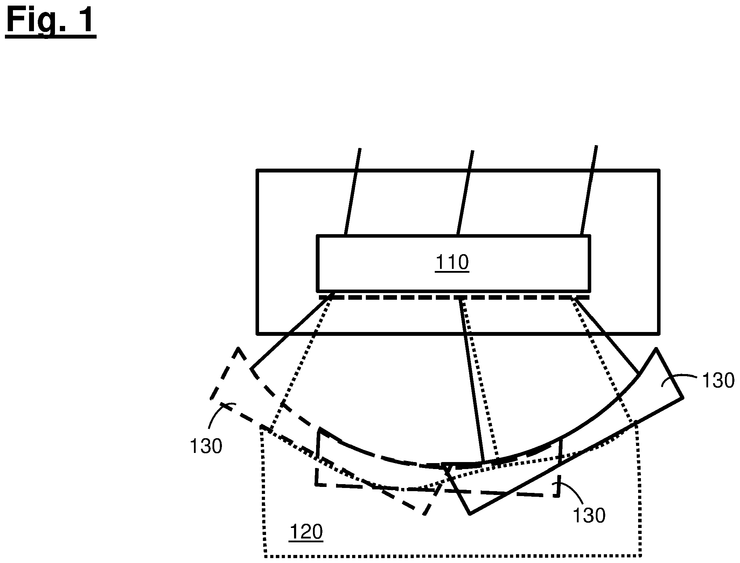

Fig. 1 zeigt eine schematische Darstellung zur Veranschaulichung einer Realisierung des erfindungsgemäßen Verfahrens zum Kalibrieren einer sphärischen Welle in einem ersten Anwendungsbeispiel. Hierbei wird die zu kalibrierende sphärische Welle von einem CGH 110 erzeugt und dient selbst als Kalibrierwelle in einem interferometrischen Prüfsystem zur Charakterisierung der Oberflächenform eines asphärischen Prüflings 120, wobei das entsprechende interferometrische Prüfsystem z.B. einen Aufbau besitzen kann, wie er vorstehend anhand von Fig. 5a-5c beschrieben wurde. Im Unterschied zu dem eingangs anhand von Fig. 6 beschriebenen herkömmlichen Konzept erfolgt nun erfindungsgemäß die Kalibrierung der vom CGH 110 ausgehenden sphärischen Welle über einen vergleichsweise (insbesondere relativ zum Prüfling 120) kleineren sphärischen Kalibrierspiegel 130 und in einer Mehrzahl von nacheinander durchgeführten interferometrischen Messungen, wobei bei jeder dieser interferometrischen Messungen jeweils nur ein Teilbereich der zu kalibrierenden sphärischen Welle erfasst bzw. vom sphärischen Kalibrierspiegel 130 reflektiert wird.

Wie in Fig. 1 weiter angedeutet erfolgt diese Erfassung unterschiedlicher Teilbereiche der zu kalibrierenden sphärischen Welle dadurch, dass der verwendete sphärische Kalibrierspiegel 130 in unterschiedliche Positionen bewegt wird. Wie ebenfalls aus Fig. 1 ersichtlich weisen jeweils zwei in unterschiedlichen dieser interferometrischen Messungen erfasste benachbarte Teilbereiche der zu kalibrierenden sphärischen Welle einen gemeinsamen Überlappbereich auf, wobei dieser Überlappbereich für die anschließende Verrechnung der erhaltenen Messergebnisse (unter Realisierung eines "Stitching-Konzepts") genutzt wird.

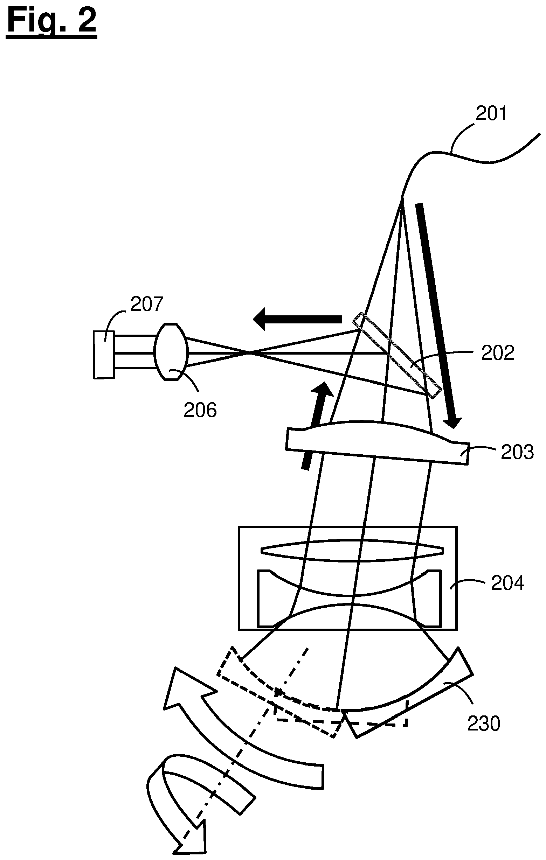

Fig. 2 zeigt eine schematische Darstellung zur Erläuterung einer weiteren möglichen Anwendung des erfindungsgemäßen Verfahrens zum Kalibrieren einer sphärischen Welle. Hierbei handelt es sich bei der zu kalibrierenden sphärischen Welle selbst um eine Prüfwelle, welche in einem interferometrischen Prüfsystem zur Charakterisierung der Oberflächenform eines sphärischen Prüflings dient. In diesem Prüfsystem gelangt - insoweit analog zu dem eingangs anhand von Fig. 7 beschriebenen herkömmlichen Aufbau - elektromagnetische Strahlung über eine optische Faser 201 und einen Strahlteiler 202 zu einem als Fizeau-Kollimator ausgestalteten Fizeau-Element 203, wobei die (zu kalibrierende) sphärische Prüfwelle aus der vom Fizeau-Element 203 ausgehenden kollimierten Welle über eine ("Aplanar")-Optik 204 erzeugt wird. Nach Reflexion am (in Fig. 2 nicht dargestellten) sphärischen Prüfling gelangt die Prüfwelle über die Optik 204 und das Fizeau-Element 203 zurück zum Strahlteiler 202 und wird von diesem über ein Okular 206 zu einer Interferometerkamera 207 gelenkt.

Zur Kalibrierung der o.g. sphärischen Prüfwelle wird nun erfindungsgemäß - insoweit analog zum vorstehend anhand von Fig. 1 beschriebenen Konzept - ein vergleichsweise (insbesondere relativ zum eigentlichen Prüfling) kleiner sphärischer Kalibrierspiegel 230 verwendet und wie in Fig. 2 angedeutet in unterschiedliche Positionen bewegt, um in einer Mehrzahl nacheinander durchgeführter interferometrischer Messungen unterschiedliche Teilbereiche der zu kalibrierenden sphärischen Welle zu erfassen.

Den vorstehend beschriebenen Ausführungsformen der Erfindung ist gemeinsam, dass zum Kalibrieren einer sphärischen Welle eine Mehrzahl von interferometrischen Messungen nacheinander durchgeführt werden, welche sich hinsichtlich des bei der jeweiligen interferometrischen Messung reflektierten Teilbereichs der zu kalibrierenden sphärischen Welle voneinander unterscheiden. Die besagten Teilbereiche sind wiederum so gewählt, dass zum einen jeweils zwei Teilbereiche einen gemeinsamen Überlappbereich aufweisen und zum anderen die Teilbereiche insgesamt in Kombination die gesamte zu kalibrierende sphärischen Welle ergeben. Dabei kann die "Umstellung" von einem Teilbereich der zu kalibrierenden sphärischen Welle auf einen anderen Teilbereich der zu kalibrierenden sphärischen Welle durch Bewegung des für die Kalibrierung verwendeten sphärischen Kalibrierspiegels, vorzugsweise durch Manipulation einer Drehstellung und/oder Schiebestellung dieses sphärischen Kalibrierspiegels, erfolgen. "Schieben" und "Drehen" bezeichnen hierbei jeweils Rotationen der entsprechenden reflektierenden Spiegelfläche bzw. der optischen Wirkfläche um durch den Krümmungsmittelpunkt der optischen Wirkfläche verlaufende, voneinander verschiedene Achsen, wobei die Rotation um eine Zylinderachse des Spiegelkörpers erfolgt.

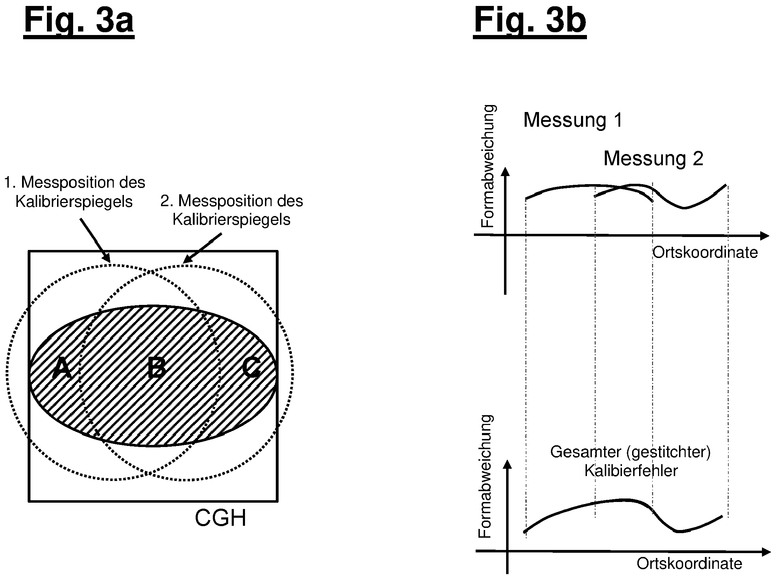

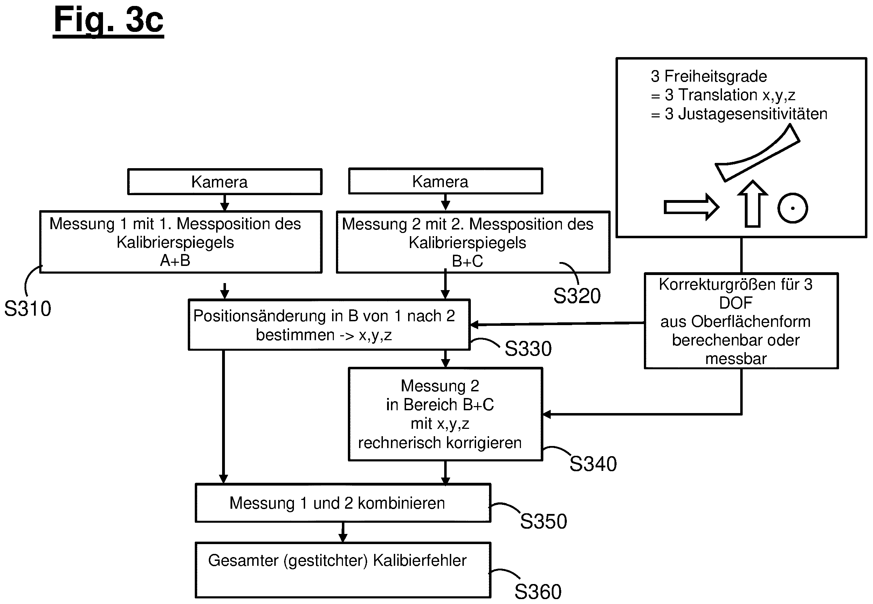

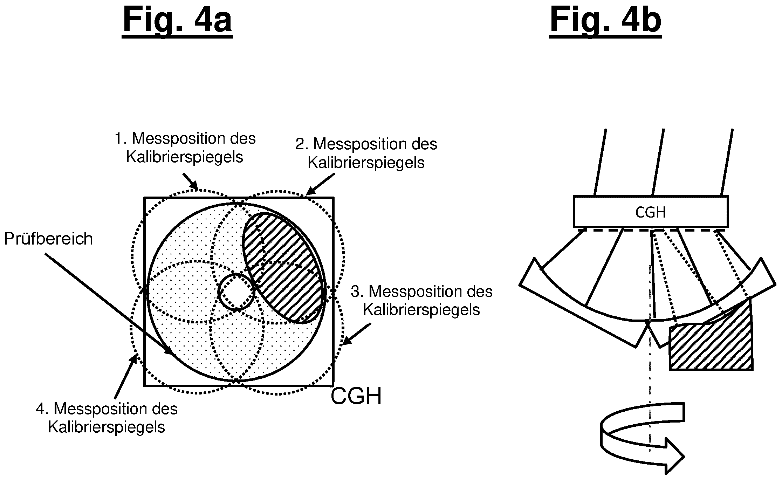

Im Weiteren wird jeweils ein typischer möglicher Ablauf des erfindungsgemäßen Verfahrens zum Kalibrieren einer sphärischen Welle, welches beispielsweise mit einer erfindungsgemäßen Messanordnung in einer der vorstehend anhand von Fig. 1 und Fig. 2 beschriebenen Ausführungsformen realisierbar ist, anhand unterschiedlicher Ausführungsformen unter Bezugnahme auf Fig. 3a-3c bzw. Fig. 4a-4c erläutert. Dabei ist in Fig. 3a-3c ein möglicher Ablauf für den Fall einer Einstellung von insgesamt zwei unterschiedlichen Positionen des für die Kalibrierung verwendeten sphärischen Kalibrierspiegels dargestellt. Gemäß der Ausführungsform von Fig. 3a-3c umfasst somit das erfindungsgemäße Verfahren die zeitlich nacheinander erfolgende Durchführung von zwei interferometrischen Messungen unter jeweiliger Einstellung unterschiedlicher Messpositionen des für die Kalibrierung verwendeten sphärischen Kalibrierspiegels und für zwei voneinander verschiedene Teilbereiche der zu kalibrierenden sphärischen Welle. Die genannten Messungen werden gemäß dem Flussdiagramm von Fig. 3c in den Schritten S310 und S320 durchgeführt. Die von den unterschiedlichen interferometrischen Messungen jeweils erfassten Teilbereiche "A+B" und "B+C" weisen wie schon erwähnt und in Fig. 3a angedeutet einen gemeinsamen Überlappbereich "B" auf.

In einem nachfolgenden Schritt S330 erfolgt anhand der Differenz der bei der interferometrischen Messung für den Überlappbereich "B" erhaltenen Messdaten eine Bestimmung der Positionsänderung zwischen "Messung 1" und "Messung 2". Dazu wird die Differenz unter Zuhilfenahme eines geeigneten Optimierungsalgorithmus bestmöglich durch die Korrekturgrößen für die translatorischen Freiheitsgrade x, y, und z angepasst, d.h. die Abweichung zwischen den Messungen wird im Überlappbereich minimiert. Hierbei wird unter "Korrekturgröße" (oder Korrekturkoeffizient oder Korrekturparameter) die erwartete Änderung der beobachteten Messung bei einer Änderung des zugehörigen Starrkörperfreiheitsgrads verstanden. Die Korrekturgröße kann aus dem Design berechnet oder empirisch durch Messung bestimmt werden. Im Ergebnis ist bei der Kalibrierung eine Genauigkeit von unter 1 nm erreichbar. Im Schritt S340 werden sämtliche in "Messung 2" erhaltenen Messdaten entsprechend der zuvor bestimmten Positionsänderung unter Zuhilfenahme der Korrekturgrößen für den gesamten Bereich "B+C" rechnerisch korrigiert. Sodann werden im Schritt S350 die Messdaten aus "Messung 1" und "Messung 2" kombiniert, was z.B. durch Mittelwertbildung im Bereich "B" erfolgen kann. Im Schritt 360 wird der gesamte (gestitchte) Kalibierfehler berechnet.

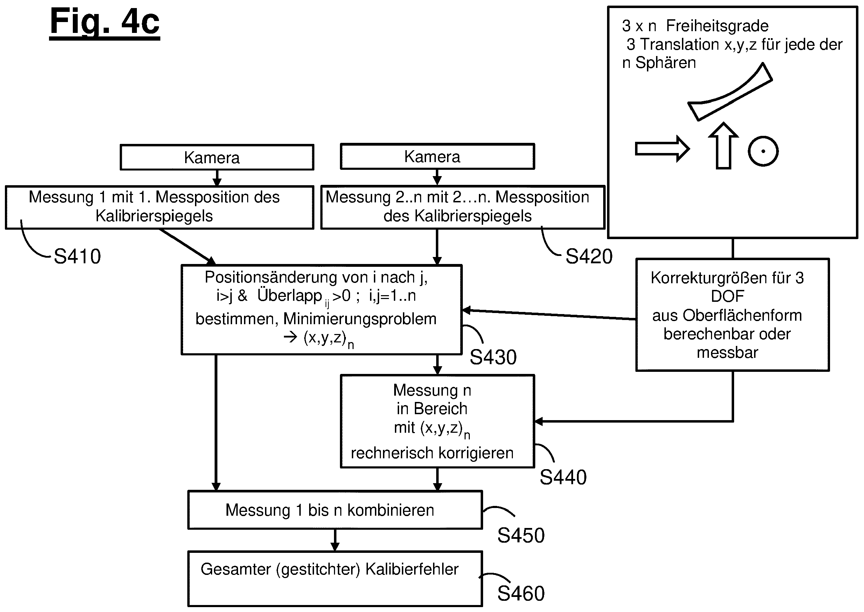

Das erfindungsgemäße Verfahren ist mit einer beliebigen Anzahl von Positionen des für die Kalibrierung verwendeten sphärischen Kalibrierspiegels zur Erfassung einer entsprechenden Anzahl von Teilbereichen der zu kalibrierenden sphärischen Welle realisierbar. In Fig. 4a-4c ist lediglich beispielhaft eine Realisierung mit vier "Sphärenpositionen" veranschaulicht, wobei Fig. 4a die erfassten Teilbereiche der zu kalibrierenden sphärischen Welle einschließlich der resultierenden Überlappbereiche zeigt. In analoger Anwendung des vorstehend anhand von Fig. 3c beschriebenen Verfahrens werden gemäß Fig. 4c in sämtlichen Überlappbereichen die translatorischen Freiheitsgrade x, y, und z so bestimmt, dass die Abweichung in den Überlappbereichen minimiert wird. Hierbei wird lediglich beispielhaft "Messung 1" als fest definiert, wobei die übrigen Messungen entsprechend angepasst werden. Das entsprechende Optimierproblem kann insbesondere durch Minimierung der quadratischen Abweichungen (RMS) gelöst werden.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind und die Reichweite der Erfindung nur im Sinne der beigefügten Patentansprüche und deren Äquivalente beschränkt ist.

## Patentansprüche

1. Verfahren zum Kalibrieren einer sphärischen Welle, wobei diese sphärische Welle in einem Prüfsystem erzeugt wird, welches zur interferometrischen Bestimmung der Oberflächenform eines Prüflings (120) ausgelegt ist, und wobei zum Kalibrieren der sphärischen Welle wenigstens ein sphärischer Kalibrierspiegel (130, 230) verwendet wird, auf welchen die sphärische Welle gelenkt wird,
**dadurch gekennzeichnet, dass**
das Kalibrieren der sphärischen Welle basierend auf einer Mehrzahl von nacheinander durchgeführten interferometrischen Messungen erfolgt, welche sich hinsichtlich des jeweils von dem sphärischen Kalibrierspiegel (130, 230) reflektierten Teilbereichs der zu kalibrierenden sphärischen Welle voneinander unterscheiden.

2. Verfahren nach Anspruch 1, **dadurch gekennzeichnet, dass** zur Reflexion der unterschiedlichen Teilbereiche der sphärischen Welle ein- und derselbe sphärische Kalibrierspiegel (130, 230) in unterschiedliche Positionen bewegt wird.

3. Verfahren nach Anspruch 1 oder 2, **dadurch gekennzeichnet, dass** wenigstens zwei in unterschiedlichen dieser interferometrischen Messungen erfasste Teilbereiche der sphärischen Welle einen gemeinsamen Überlappbereich aufweisen.

4. Verfahren nach Anspruch 3, **dadurch gekennzeichnet, dass** eine rechnerische Korrektur der in der Mehrzahl von interferometrischen Messungen jeweils erhaltenen Messdaten unter Berücksichtigung von relativen Abweichungen der für den Überlappbereich jeweils erhaltenen Messdaten erfolgt.

5. Verfahren nach einem der vorhergehenden Ansprüche, **dadurch gekennzeichnet, dass** die Anzahl der sich hinsichtlich des reflektierten Teilbereichs der zu kalibrierenden sphärischen Welle voneinander unterscheidenden durchgeführten interferometrischen Messungen wenigstens drei, insbesondere wenigstens vier, beträgt.

6. Verfahren nach einem der Ansprüche 1 bis 5, **dadurch gekennzeichnet, dass** die sphärische Welle in dem Prüfsystem als Prüfwelle bei der interferometrischen Bestimmung der Oberflächenform eines sphärischen Prüflings erzeugt wird.

7. Verfahren nach einem der Ansprüche 1 bis 5, **dadurch gekennzeichnet, dass** die sphärische Welle in dem Prüfsystem als Kalibrierwelle bei der interferometrischen Bestimmung der Oberflächenform eines asphärischen Prüflings (120) erzeugt wird.

8. Verfahren nach Anspruch 7, **dadurch gekennzeichnet, dass** bei dieser interferometrischen Bestimmung der Oberflächenform des asphärischen Prüflings (120) eine durch Beugung elektromagnetischer Strahlung an einem Computer-generierten Hologramm (CGH) (110) erzeugte und an dem Prüfling (120) reflektierte Prüfwelle mit einer nicht an dem Prüfling (120) reflektierten Referenzwelle überlagert wird.

9. Verfahren nach einem der vorhergehenden Ansprüche, **dadurch gekennzeichnet, dass** der Prüfling (120) ein optisches Element einer mikrolithographischen Projektionsbelichtungsanlage ist.

10. Verfahren nach einem der vorhergehenden Ansprüche, **dadurch gekennzeichnet, dass** der Prüfling (120) ein Spiegel oder eine Linse ist.

11. Prüfsystem zur interferometrischen Bestimmung der Oberflächenform eines Prüflings, insbesondere eines optischen Elements einer mikrolithographischen Projektionsbelichtungsanlage, wobei das Prüfsystem zum Kalibrieren einer in dem Prüfsystem erzeugten sphärische Welle einen sphärischen Kalibrierspiegel (130, 230) aufweist, welcher zur Reflexion unterschiedlicher Teilbereiche der sphärischen Welle in unterschiedliche Positionen bewegbar ist.

12. Prüfsystem nach Anspruch 11, **dadurch gekennzeichnet, dass** dieses dazu ausgelegt ist, ein Verfahren nach einem der Ansprüche 1 bis 10 durchzuführen.
